# EUROPÄISCHE PATENTSCHRIFT

(11) **EP 1 759 913 B1**
(45) Veröffentlichungstag und Bekanntmachung des Hinweises auf die Patenterteilung: **05.10.2011**
(21) Anmeldenummer: 06016691.5
(22) Anmeldetag: 10.08.2006
(51) Int. Cl.: G01R 31/12, B60L 3/00

(54) **Verfahren und Einrichtung zur Erfassung und Überwachung von Isolationsstrecken und Berührungsspannungen im Trolley-Bus**
Method and apparatus for detecting and monitoring the isolation distances and chassis-contact voltage of a trolley-bus
Méthode et dispositif de détection et surveillance de la distance d'isolement et la tension de contact d'un châssis d'un trolleybus

(30) Priorität: 01.09.2005 DE 102005041511
(43) Veröffentlichungstag der Anmeldung: 07.03.2007
(73) Patentinhaber: Vossloh Kiepe GmbH, 40599 Düsseldorf (DE)
(72) Erfinder: Winand, Helmut, 42657 Solingen (DE)
(74) Vertreter: Feder Walter Ebert

(56) Entgegenhaltungen:
- EP-A- 1 093 957
- DE-C1- 4 037 860
- GB-A- 2 346 020
- US-A- 5 155 441

## Beschreibung

Die Erfindung betrifft ein Verfahren und eine Einrichtung zur Erfassung und Überwachung von Isolationsstrecken und Berührungsspannungen im Trolley-Bus mit den Merkmalen aus dem Oberbegriff des Patentanspruchs 1 sowie eine Einrichtung zur Durchführung des Verfahrens mit den Merkmalen aus dem Oberbegriff des Patentanspruchs 16.

Trolley-Busse als Reifenfahrzeuge weisen keine sichere Verbindung des Chassis mit der Erde auf. Insofern müssen bei ihnen zum Schutz gegen gefährliche Berührungsspannungen besondere Schutzmaßnahmen eingesetzt werden. Deswegen ist die gesamte elektrische Anlage zweifach oder verstärkt gegenüber dem Chassis isoliert, zudem können die Einstiegspartien eine dritte Isolation als zusätzlichen Schutz aufweisen. Bei einem Trolley-Bus besteht die Notwendigkeit, die lsolationsstrecken zu überwachen und zu kontrollieren, da ein Trolley-Bus im besonderen Maße ständig der Witterung, Verschmutzung und Erschütterung ausgesetzt ist.

Ein Verfahren und eine Einrichtung zur Erfassung und Überwachung der Berührungsspannung am Chassis von Trolley-Bussen werden in der Patenschrift EP 1 093 957 B1 beschrieben. Zur Spannungsmessung zwischen Chassis und Erde wird hier eine Spannungsmessvorrichtung verwendet. Der gemessene Spannungswert und seine Anlegezeit wird mit den Werten mindestens einer vorgegebenen Spannungs/Zeit-Kennlinie mittels einer Analog-Schaltung verglichen, und sobald die gemessenen Spannungswerte größer als die entsprechenden Werte auf mindestens einer dieser Kennlinien sind, wird ein Alarmsignal und/oder ein Abschaltvorgang ausgelöst. Es wird hierbei ein auf Grund nicht konstanter Belastung entstehender Spannungsabfall an der Oberleitung berücksichtigt, welcher ansonsten zu einer Verfälschung der Messergebnisse führen würde. Es wird deswegen zwischen die Spannungsmessvorrichtung und den geerdeten Pol der Oberleitung eine Kompensationsspannung eingeschaltet, so dass die Spannung zwischen Chassis und einem belastungsunabhängigen virtuellen Potenzial gemessen wird. Das beschriebene Verfahren ist darauf ausgelegt, das Chassis des Trolley-Busses bezüglich Überspannungen zu überwachen. Insofern wird stets nur die gesamte Isolationsstrecke zwischen Oberleitung und Chassis kontrolliert.

Falls eine Überspannung detektiert worden ist, muss anschließend vom Wartungspersonal der Grund für die Überspannung gesucht werden, damit der Fehler, welcher zur Überspannung am Chassis geführt hat, behoben werden kann. Diese Fehlersuche ist aufwendig und zeitintensiv.

Aufgabe der Erfindung ist, ein Verfahren und eine Einrichtung derart auszugestalten, dass neben der Gesamtisolationsstrecke auch die Zwischenisolationsstrecken im Betrieb des Trolley-Busses einzeln überwacht werden können, und dass die Fehlersuche vereinfacht wird.

Die Lösung der Aufgabe erfolgt erfindungsgemäß verfahrensmäßig mit den Merkmalen aus dem kennzeichnenden Teil des Patentanspruchs 1 sowie einrichtungsmäßig mit den Merkmalen aus dem kennzeichnenden Teil des Patentanspruchs 16.

Erfindungsgemäß wird nicht nur mittels einer Chassis-Spannungsmessvorrichtung die Differenz zwischen Chassispotenzial und einem Bezugspotenzial (d.h. der Chassis-Spannungswert) gemessen, sondern es wird auch mittels einer Zwischen-Spannungsmessvorrichtung an mindestens einem Zwischenpunkt der Isolations-Zwischenebene die Differenz zwischen Zwischenpotenzial und einem Bezugspotenzial (d.h. der Zwischen-Spannungswert) gemessen, wobei das Bezugspotenzial insbesondere gleich dem Potenzial des geerdeten Poles der Oberleitung ist. Dieses virtuelle Erdpotenzial ist von der Belastung der Oberleitung abhängig. Für die Messungen wird ein Mikroprozessor eingesetzt, dem die Spannungswerte über einen Spannungsteiler an dessen AnalogEingang zugeführt werden können. Die gemessenen Spannungswerte und seine Anlegezeit können mittels des Mikroprozessors mit den Werten mindestens einer vorgegebenen und dem Mikroprozessor zugänglichen Spannungs/Zeit-Kennlinie verglichen werden, und sobald die gemessenen Spannungswerte größer als die entsprechenden Werte auf mindestens einer dieser Kennlinien sind, kann ein Alarmsignal generiert werden.

Vorteilhafterweise kann, sobald eine Überspannung an einem Zwischenpunkt oder am Chassis detektiert worden ist, der Fehlerort gespeichert werden, um dem Wartungspersonal die Fehlersuche zu vereinfachen.

In einer besonders vorteilhaften Ausgestaltung kann durch ein Leucht-Mittel, insbesondere eine Leuchtdiode, angezeigt werden, wenn der gemessene Chassis-Spannungswert und/oder der Zwischen-Spannungswert einen vorgegebenen Wert überschreitet, wobei jedem Zwischenpunkt ein Leucht-Mittel, insbesondere eine Leuchtdiode, zugeordnet werden kann, so dass dadurch angezeigt werden kann, an welchem Zwischenpunkt der gemessene Zwischen-Spannungswert einen vorgegebenen Wert überschreitet. Die Leuchtdioden erlöschen nicht unmittelbar, nachdem die gemessene Spannung wieder unter den vorgegebenen Wert sinkt, damit der Fehlerort dem Wartungspersonal angezeigt werden kann. Vorteilhafterweise können die Leuchtdioden derart angeordnet sein, dass sie in einfacher Weise vom Wartungspersonal gesehen werden können.

Dadurch, dass auch die Isotations-Zwischenstrecken überwacht werden, entsteht die Möglichkeit einer differenzierteren Bewertung von Fehlerzuständen. Ist beispielweise eine Isotationsstrecke zwischen der Oberleitung und einem Zwischenpunkt defekt, nicht aber die Isolationsstrecke zwischen Zwischenpunkt und Chassis, so besteht nicht die unmittelbare Notwendigkeit, den Betrieb des Trolley-Busses sofort einzustellen. Der Fehler kann aber derart gespeichert werden, dass dem Wartungspersonal die Fehlersuche vereinfacht wird.

In einer weiteren Ausführung kann vorgesehen sein, dass eine Spannung an das Chassis oder an die Zwischenpunkte angelegt wird, so dass eine Überspannung simuliert wird. Dies hat zum einen den Vorteil, dass auch die Isolationsüberwachung selber geprüft werden kann. Zum anderen ist es nunmehr möglich, bei Anlegen einer Spannung an die Zwischenpunkte einen Fehler zwischen einem Zwischenpunkt und dem Chassis zu detektieren.

In einer vorteilhaften Ausgestaltung kann, bei mit der Belastung schwankender Spannung der Oberleitung, die Spannung zwischen Chassis bzw. Zwischenpunkt und einem belastungsunabhängigen virtuellen Potenzial gemessen werden, wobei fortlaufend die Spannung zwischen den beiden Polen der Oberleitung gemessen wird, und zur Kompensation der Schwankung der Messwert von der Oberleitungsspannung verwendet wird. Vorteilhafterweise kann somit auf die aus dem Stand der Technik bekannte Kompensation-Spannungsquelle verzichtet werden, da die Kompensation rechnerisch im Mikroprozessor M erfolgen kann. Unter der Voraussetzung, dass der Minuspol der Oberleitung an allen Unterwerken geerdet ist und die Leerlaufspannung aller Unterwerke gleich und bekannt ist, kann so die exakte Fehlerspannung eines jeden Messpunktes gegen Erde ermittelt werden.

Als Vorteil der Erfindung erweist sich des Weiteren, dass sich das erfindungsgemäße Verfahren und die erfindungsgemäße Einrichtung sehr stabil gegenüber transienten Vorgängen, welche nun nur noch in geringem Maße zu Fehlerauslösungen führen, und parasitären Kapazitäten erweisen.

Ein mögliches Ausführungsbeispiel der Erfindung ist in den Figuren 1-5 dargestellt.

Es zeigen:
- Fig. 1: ein Ersatzschaltbild der Isolationsstrecken in einem Trolley-Bus
- Fig. 2: ein Ersatzschaltbild der Überwachungsschaltung Teil A
- Fig. 3: ein Ersatzschaltbild der Überwachungsschaltung Teil B
- Fig. 4: eine Spannungs/Zeit-Kennlinie
- Fig. 5a: ein Ersatzschaltbild mit eingezeichnetem Strompfad bei einem Chassis-Isolationsfehler
- Fig. 5b: ein Ersatzschaltbild mit eingezeichnetem Strompfad bei einem Zwischenpunkt-Isolationsfehler
- Fig. 5c: ein Ersatzschaltbild mit eingezeichnetem Strompfad bei einem Test der Chassis-Spannungsmessung
- Fig. 5d: ein Ersatzschaltbild mit eingezeichnetem Strompfad bei einem Test der Zwischenpunkt-Spannungsmessung
- Fig. 5e: ein Ersatzschaltbild mit eingezeichnetem Strompfad bei einem Test der Zwischenpunkt-Spannungsmessung bei gleichzeitigem Isolationsfehler zwischen einem Zwischenpunkt und dem Chassis

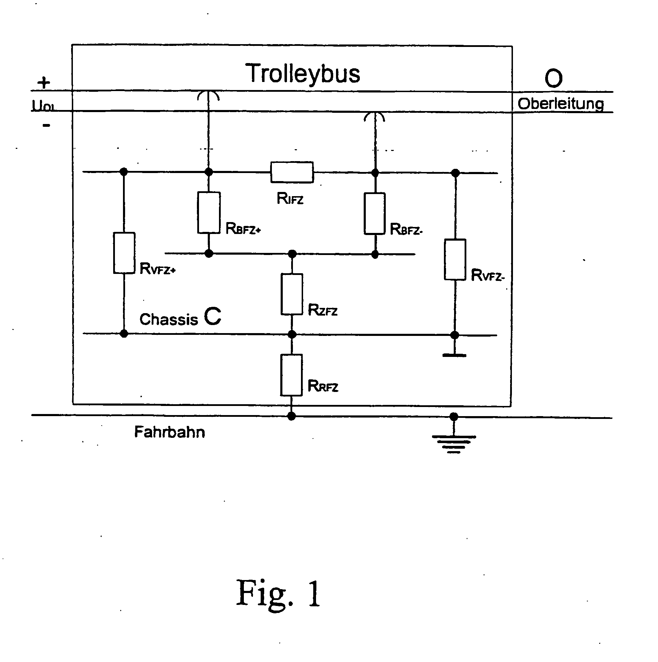

Die Fig. 1 zeigt ein Ersatzschaltbild der Isolationsstrecken in einem Trolley-Bus, welcher an einer Oberleitung O mit einem positiven Pol (+) und einem negativen Pol (-) betrieben wird, wobei der negative Pol im Unterwerk an einem Punkt geerdet ist. Das Chassis C ist zum einen über eine verstärkte Isolation (R_{VFZ+} und R_{VFZ-}) sowie über eine zweistufige Isolation mit der Oberleitung O verbunden. Die zweistufige Isolation besteht aus einer Betriebsisolation (R_{BFZ+} und R_{BFZ-}), welche sich zwischen der Isotations-Zwischenebene und der Oberleitung O befindet, sowie einer Zusatzisolation (R_{ZFZ}), welche sich zwischen der Isolations-Zwischenebene und dem Chassis C befindet. Das Chassis C ist mit einem Übergangswiderstand (R_{RFZ}) der Reifen mit der Fahrbahn verbunden.

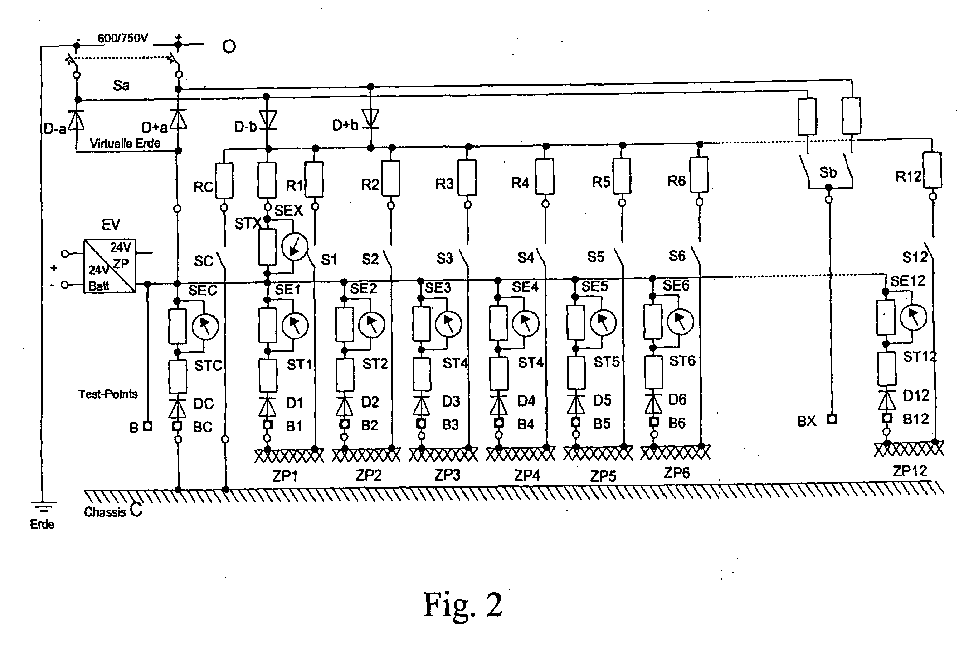

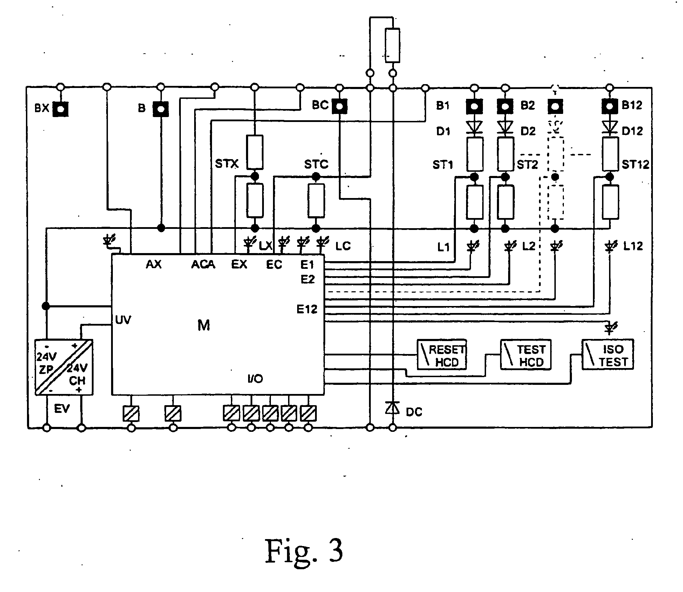

Die Fig. 2 zeigt den Teil A eines Ersatzschaltbilds der Überwachungsschaltung. Dargestellt sind die Oberleitung O, das Chassis C sowie mehrere Zwischenpunkte ZP1 bis ZP12. Das Chassis C ist über eine Diode DC, eine Chassis-Spannungsmessvorrichtung, welche eine Spannungserfassung SEC und einen Spannungsteiler STC beinhaltet, eine Diode D-a bzw. eine Diode D+a sowie einen Schalter Sa mit der Oberleitung O verbunden. Jeder Zwischenpunkt ist über eine Diode D1 bis D12, jeweils eine Zwischen-Spannungsmessvorrichtung, welche jeweils eine Spannungserfassung SM1 bis SM12 sowie einen Spannungsteiler ST1 bis ST12 beinhaltet, die Diode D-a bzw. die Diode D+a sowie den Schalter Sa mit der Oberleitung O verbunden.
Die Spannungsmessvorrichtungen sind in der weiter unten beschriebenen Fig. 3, welchen den Teil B des Ersatzschaltbilds der Überwachungsschaltung zeigt, im Detail dargestellt.

An das Chassis C kann zu Testzwecken eine Spannung angelegt werden. Dafür wird der Schalter SC geschlossen, so dass das Chassis C über einen Widerstand RC, eine Diode D-b bzw. eine Diode D+b über den Schalter Sa mit der Oberleitung 0 verbunden ist.

In gleicher Weise kann an jeden Zwischenpunkt ZP1 bis ZP12 zu Testzwecken eine Spannung angelegt werden. Dafür wird einer oder mehrere der Schalter S1 bis S12 geschlossen, so dass einer oder mehrere der Zwischenpunkte über einen Widerstand R1 bis R12, der Diode D-b bzw. der Diode D+b über den Schalter Sa mit der Oberleitung O verbunden ist.
Über den Spannungsteiler STX sowie die Spannungserfassung SEX kann die Oberleitungsspannung gemessen werden, welche für die Spannungskompensation verwendet wird.
Über die Messbuchse BX lässt sich ein Isotationsprüfgerät anschließen, mit welchem bei geschlossenem Schalter Sb die im Betrieb mit der Oberleitung O verbundenen Teile der Anlage über weitere Messbuchsen (BC, B1 bis B12) gegen die anderen Zwischenpunkte bzw. gegen das Chassis gemessen werden können.

Die Fig. 3 zeigt den Teil B des Ersatzschaltbilds der Überwachungsschaltung. Es sollen im folgenden nur die wesentlichen Elemente beschrieben werden. Dargestellt sind die Spannungsteiler ST1 bis ST12. Als zusammengefasste Spannungserfassung ist hier ein Mikroprozessor M dargestellt, welcher die Funktion der einzelnen Spannungserfassungen SE1 bis SE12 übernimmt. Der Mikroprozessor M wird von einer eigenen, sowohl von der Fahrzeugbatterie als auch von der Oberleitung O entkoppelten Energieversorgungseinheit EV mit Energie versorgt und mit der Messbuchse B verbunden. Dem Mikroprozessor M werden an dessen analogen Eingängen (EX, EC und E1 bis E12) die von den Spannungsteilern (STX, STC und ST1 bis ST12) heruntergeteilten Spannungen zugeführt. Die Ansteuerung der Schalter für den Test erfolgt über die Ausgänge AX, AC und A.

An den Mikroprozessor sind Leuchtdioden LX, LC und L1 bis L12 angeschlossen.

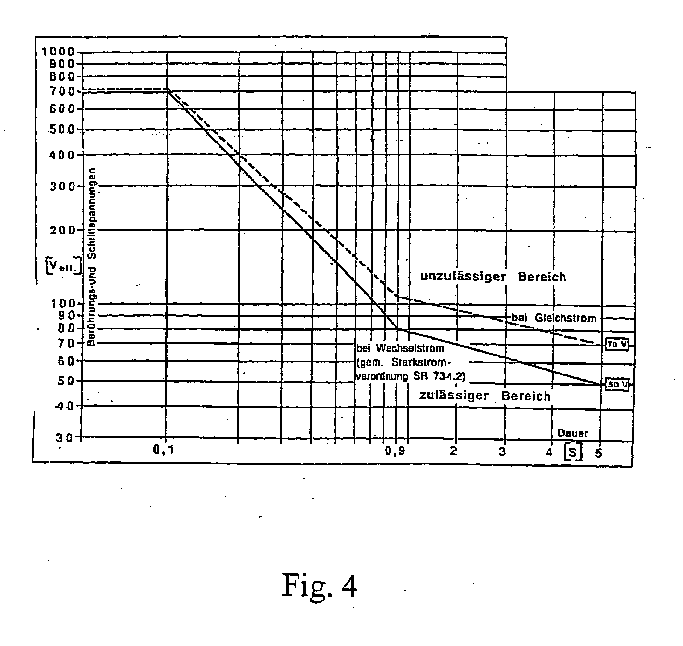

In dem Mikroprozessor M ist eine Spannungs-/Zeit-Kennlinie hinterlegt. Die Spannungs/Zeit-Kennlinie ist in Fig. 4 dargestellt. Sie zeigt, ab welcher Zeit eine Berührungsspannung für einen durchschnittlichen Menschen gesundheitsgefährlich ist. Insofern stellen Werte oberhalb der Kurve einen unzulässigen Bereich, Werte unterhalb der Kurve einen zulässigen Bereich dar.

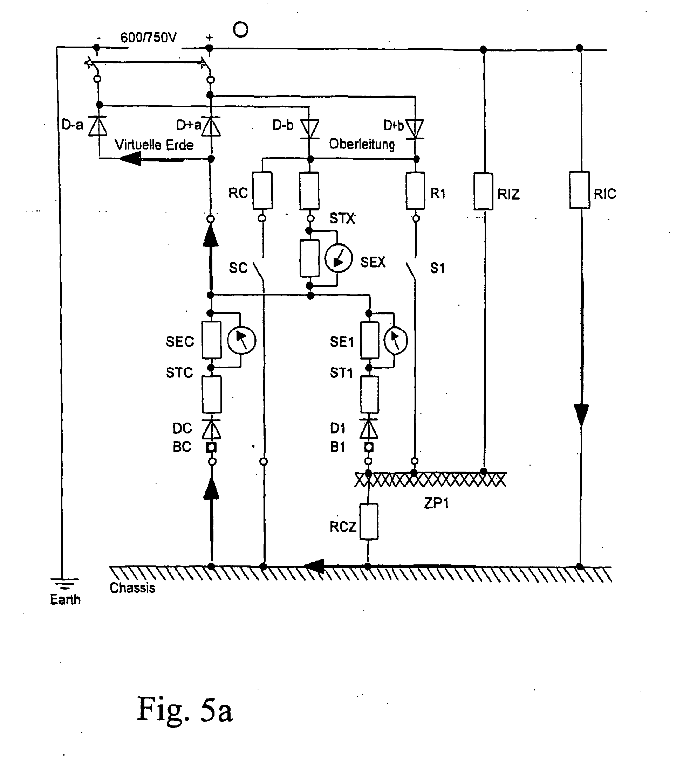

Die Kurve markiert die für die Chassisspannung zulässigen Chassis-Spannungswerte in Abhängigkeit von der Anlegezeit. Der Mikroprozessor M misst laufend die Chassis-Spannungswerte. Kommt es zu einem Chassis-Isotationsfehter (Isolationsstrecke RIC), ergibt sich der in Fig. 5a dargestellte Strompfad. Sobald der gemessene Chassis-Spannungswert und seine Anlegezeit größer als die entsprechenden Werte auf der in Fig. 4 dargestellten Spannungs/Zeit-Kennlinie sind, wird ein Alarmsignal generiert.

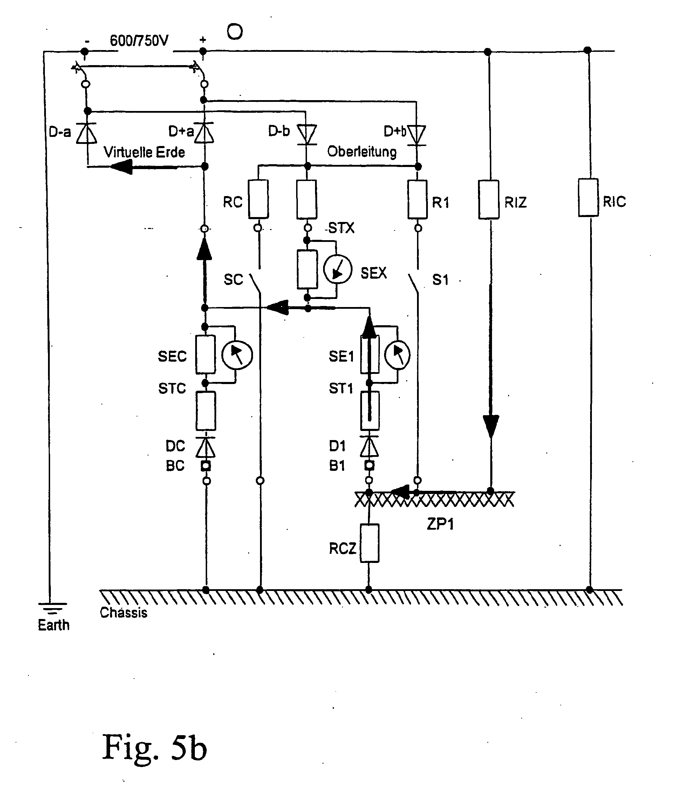

Der Mikroprozessor M überwacht desweiteren die Zwischenpunkt-Spannungswerte. Kommt es zu einem Zwischenpunkt-Isolationsfehler (Isolationsstrecke RIZ), ergibt sich der in Fig. 5b dargestellte Strompfad. Sobald ein Zwischenpunkt-Spannungswert über einem vorgegebenen Wert liegt, wird die dem Zwischenpunkt zugeordnete Leuchtdiode aktiviert. Sie bleibt solange aktiviert, bis vom Wartungspersonal durch Druck der RESET-Taste der Ausgangszustand der Schaltung wiederhergestellt wird. Hierdurch wird die Fehlersuche bei transienten Fehlern stark vereinfacht.

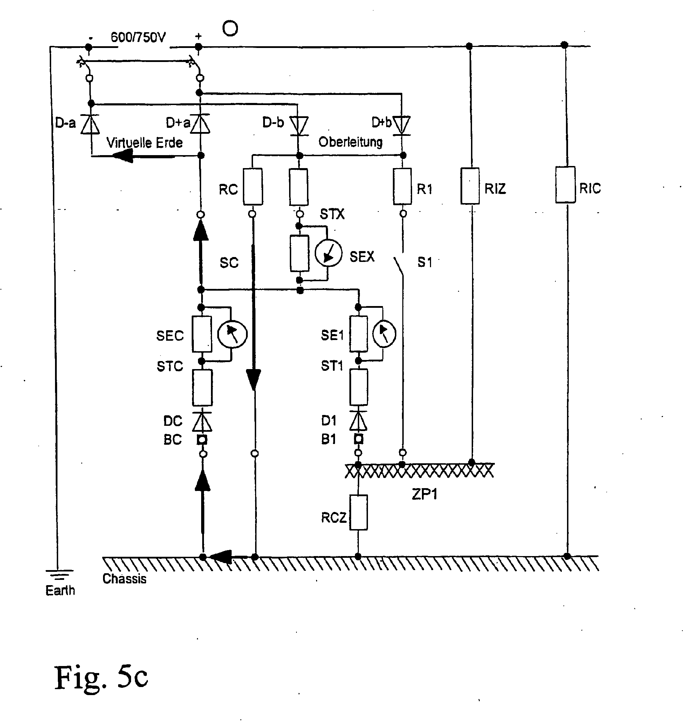

Die Überwachungsschaltung eignet sich ferner zur Selbstüberwachung. Zur Selbstüberwachung der Chassis-Spannungsmessung wird der in Fig. 2 dargestellte Schalter SC geschlossen, wobei sich der in Fig. 5c dargestellte Strompfad ergibt. Durch Vergleich der gemessenen Spannung mit der erwarteten Spannung, welche auf Grund des konstanten Widerstandes RC sowie dem bekannten Teilerverhältnis des Spannungsteilers STC bekannt ist, wird die Chassis-Spannungsmessvorrichtung getestet.

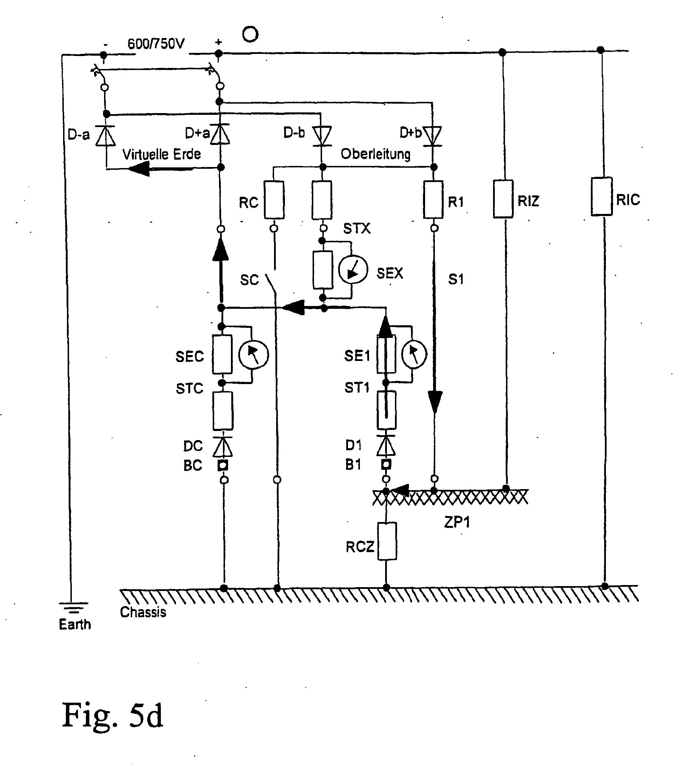

In der gleichen Weise eignet sich die Überwachungsschaltung zur Selbstüberwachung der Zwischenpunkt-Spannungsmessung. Dafür wird nacheinander oder gleichzeitig jeder der Schalter S1 bis S12 geschlossen, wodurch sich beispielsweise der in Fig. 5d dargestellte Strompfad ergibt. Ebenfalls können nunmehr durch Vergleich der gemessenen Spannungen mit den erwarteten Spannungen die Zwischen-Spannungsmessvorrichtungen getestet werden.

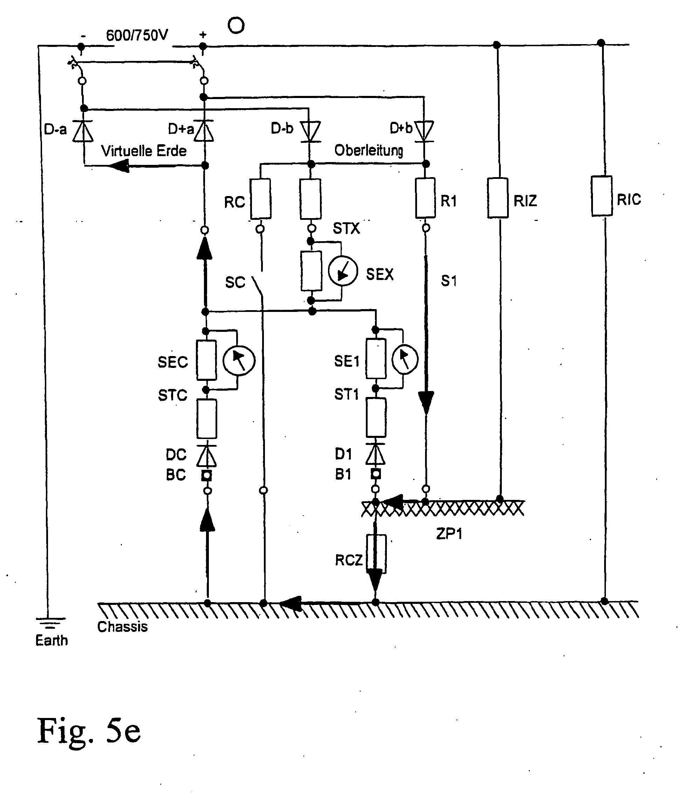

Während der Selbstüberwachung der Zwischen-Spannungsmessung können zugleich Isolationsfehler zwischen einem Zwischenpunkt und dem Chassis (Isotationsstrecke RZC) detektiert werden. Der sich ergebende Strompfad ist in Fig. 5e dargestellt.

## Patentansprüche

1. Verfahren zur Erfassung und Überwachung von Isolationsstrecken und Berührungsspannungen im Trolley-Bus,
• wobei der Trolley-Bus an ein geerdetes Oberleitungsnetz anschließbar ist,
• wobei der Trolley-Bus zwischen Chassis (C) und Oberleitung (O) ein mindestens zweistufiges Isolationssystem mit mindestens einer Isolations-Zwischenebene aufweist,
• wobei mittels einer Chassis-Spannungsmessvorrichtung die Differenz zwischen Chassispotenzial und einem Bezugspotenzial gemessen wird,
• wobei dieser gemessene Chassis-Spannungswert mit einem vorgegebenen Wert verglichen wird,
• und wobei ein Alarmsignal generiert wird, wenn der Chassis-Spannungswert einen vorgegebenen Wert überschreitet,
**dadurch gekennzeichnet,**
• **dass** mittels einer Zwischen-Spannungsmessvorrichtung an mindestens einem Zwischenpunkt der Isolations-Zwischenebene die Differenz zwischen Zwischenpotenzial und Bezugspotenzial gemessen wird,
• **dass** die Zwischen-Spannungsmessvorrichtung und/oder die Chassis-Spannungsmessvorrichtung einen Mikroprozessor (M) umfasst,
• **dass** durch den Mikroprozessor (M) dieser Zwischen-Spannungswert mit einem vorgegebenen Wert verglichen wird,
• und **dass** durch den Mikroprozessor (M) ein Alarmsignal generiert wird, wenn der Zwischen-Spannungswert einen vorgegebenen Wert überschreitet.

2. Verfahren nach Anspruch 1, **dadurch gekennzeichnet dass** das Bezugspotenzial gleich dem Erdpotenzial ist.

3. Verfahren nach Anspruch 1 oder 2 **dadurch gekennzeichnet, dass**, wenn der gemessene Chassis-Spannungswert und/oder Zwischen-Spannungswert einen vorgegebenen Wert überschreitet, dieser Chassis-Spannungswert und/oder Zwischen-Spannungswert gespeichert wird.

4. Verfahren nach einem oder mehreren der vorhergehenden Ansprüche, **dadurch gekennzeichnet, dass** durch ein Leucht-Mittel, insbesondere eine Leuchtdiode, angezeigt wird, wenn der gemessene Chassis-Spannungswert einen vorgegebenen Wert überschreitet.

5. Verfahren nach einem oder mehreren der vorhergehenden Ansprüche, **dadurch gekennzeichnet, dass** die Isolations-Zwischenebene mindestens zwei Zwischenpunkte aufweist, dass jedem Zwischenpunkt ein Leucht-Mittel, insbesondere eine Leuchtdiode, zugeordnet ist, und dass durch die Leucht-Mittel angezeigt wird, an welchem Zwischenpunkt der gemessene Zwischen-Spannungswert einen vorgegebenen Wert überschreitet.

6. Verfahren nach einem oder mehreren der vorhergehenden Ansprüche, **dadurch gekennzeichnet, dass** der gemessene Chassis-Spannungswert und seine Anlegezeit und/oder der gemessene Zwischen-Spannungswert und seine Anlegezeit mit den Werten mindestens einer vorgegebenen und dem Mikroprozessor zugänglichen Spannungs/Zeit-Kennlinie verglichen wird, die eine von hohen Spannungswerten bei kürzeren Anlegezeiten zu niedrigen Spannungswerten bei längeren Anlegezeiten abfallende Charakteristik besitzt, und dass ein Alarmsignal generiert wird, wenn die gemessenen Spannungswerte größer als die entsprechenden Werte auf mindestens einer der vorgegebenen Spannungs/Zeit-Kennlinien sind.

7. Verfahren nach Anspruch 6, **dadurch gekennzeichnet, dass** bei Überschreitung der Spannungs/Zeit-Kennlinie an einem Zwischenpunkt oder Chassis-Messpunkt der betreffende Zwischenpunkt oder Chassis-Messpunkt gespeichert und angezeigt wird.

8. Verfahren nach einem oder mehreren der vorhergehenden Ansprüche, **dadurch gekennzeichnet, dass** über einen Spannungsteiler die Differenz zwischen Chassispotenzial und Bezugspotenzial und/oder die Differenz zwischen Zwischenpotenzial und Bezugspotenzial als Analogwerte dem Analogeingang des Mikroprozessors zugeführt wird.

9. Verfahren nach einem oder mehreren der vorhergehenden Ansprüche, **dadurch gekennzeichnet, dass** nacheinander oder gleichzeitig an jeden Zwischenpunkt eine Spannung angelegt wird, und dass jeweils die Differenz zwischen-Chassispoterizial und Bezugspotenzial sowie die Differenz zwischen dem Zwischenpotenzial des Zwischenpunktes, an dem die Spannung anliegt, und Bezugspotenzial gemessen wird.

10. Verfahren nach einem oder mehreren der vorhergehenden Ansprüche, **dadurch gekennzeichnet, dass** bei mit der Belastung schwankender Spannung der Oberleitung die Spannung zwischen Chassis und/oder Zwischenpunkt und einem belastungsunabhängigen virtuellen Potenzial gemessen wird, wobei fortlaufend die Spannung zwischen den beiden Polen der Oberleitung gemessen wird, und dies zur Kompensation der Schwankung verwendet wird.

11. Verfahren nach Anspruch 1 oder einem oder mehreren der Ansprüche 3 bis 10 **dadurch gekennzeichnet, dass** das Bezugspotenzial gleich dem virtuellen Potenzial ist.

12. Verfahren nach einem oder mehreren der vorhergehenden Ansprüche, **dadurch gekennzeichnet, dass** zu Prüfzwecken nacheinander oder gleichzeitig eine Spannung an alle Zwischenpunkte angelegt wird und dass jeweils die Differenz zwischen Chassispotenzial und Bezugspotenzial gemessen wird.

13. Verfahren nach einem oder mehreren der vorhergehenden Ansprüche, **dadurch gekennzeichnet, dass** zu Prüfzwecken nacheinander oder gleichzeitig eine Spannung an alle Zwischenpunkte angelegt wird und dass jeweils die Differenz zwischen dem jeweiligen Zwischenpotenzial und Bezugspotenzial gemessen wird.

14. Verfahren nach einem oder mehreren der vorhergehenden Ansprüche, **dadurch gekennzeichnet, dass** zu Prüfzwecken eine Spannung an das Chassis angelegt wird und dass die Differenz zwischen Chassispotenzial und Bezugspotenzial gemessen wird.

15. Verfahren nach Anspruch 5, **dadurch gekennzeichnet, dass** durch Betätigen eines RESET-Schalters alle den Zwischenpunkten zugeordneten Leuchtdioden erlöschen.

16. Einrichtung zur Erfassung und Überwachung von Überspannungen an einem Trolley-Bus,
• wobei der Trolley-Bus an ein geerdetes Oberleitungsnetz angeschlossen ist,
• wobei der Trolley-Bus zwischen Chassis (C) und Oberleitung (O) ein mindestens zweistufiges Isolationssystem mit mindestens einer Isolations-Zwischenebene aufweist,
• wobei die Einrichtung eine Chassis-Spannungsmessvorrichtung umfasst, welche zwischen das Chassis (C) und den geerdeten Pol der Oberleitung (O) geschaltet ist und welche die Differenz zwischen Chassispotenzial und einem Bezugspotenzial misst,
**dadurch gekennzeichnet,**
• **dass** die Isolations-Zwischenebene mindestens einen Zwischenpunkt aufweist,
• **dass** zwischen jedem Zwischenpunkt und dem geerdeten Pol der Oberleitung (O) eine Zwischen-Spannungsmessvorrichtung geschaltet ist, welche die Differenz zwischen Zwischenpotenzial und Bezugspotenzial misst,
• und **dass** die Zwischen-Spannungsmessvorrichtung und/oder die Chassis-Spannungsmessvorrichtung einen Mikroprozessor (M) umfasst.

17. Einrichtung nach Anspruch 16, **dadurch gekennzeichnet, dass** die Chassis-Spannungsmessvorrichtung und/oder die Zwischen-Spannungsmessvorrichtung einen Spannungsteiler (STC, ST1 bis ST12) umfasst.

18. Einrichtung nach Anspruch 16 oder 17, **dadurch gekennzeichnet, dass** sie eine von der Oberleitung (O) entkoppelt Energieversorgungseinheit (EV) aufweist, welche den Mikroprozessor (M) mit Energie versorgt.

## Claims

1. Method for detecting and monitoring isolation paths and contact voltages in the trolley bus,
• wherein the trolley bus can be connected to an earthed overhead line network,
• wherein the trolley bus comprises between the chassis (C) and overhead line (0) an at least two-stage isolation system with at least one intermediate isolation level,
• wherein the difference between the chassis potential and a reference potential is measured by means of a chassis voltage measuring device,
• wherein this measured chassis voltage value is compared with a predefined value,
• and wherein an alarm signal is generated if the chassis voltage value exceeds a predefined value,
**characterised in that**
• the difference between the intermediate potential and reference potential is measured by means of an intermediate voltage measuring device at at least one intermediate point of the intermediate isolation level,
• the intermediate voltage measuring device and/or the chassis voltage measuring device comprises a microprocessor (M),
• this intermediate voltage value is compared by the microprocessor (M) with a predefined value,
• and an alarm signal is generated through the microprocessor (M) if the intermediate voltage value exceeds a predefined value.

2. Method according to claim 1, **characterised in that** the reference potential is equal to the earth potential.

3. Method according to claim 1 or 2, **characterised in that** if the measured chassis voltage value and / or intermediate voltage value exceed(s) a predefined value this chassis voltage value and / or intermediate voltage value is / are stored.

4. Method according to one or more of the preceding claims, **characterised in that** an indication is given through a lighting means, in particular a light emitting diode, if the measured chassis voltage value exceeds a predefined value.

5. Method according to one or more of the preceding claims, **characterised in that** the intermediate isolation level comprises at least two intermediate points, a lighting means, in particular a light emitting diode, is assigned to each intermediate point, and it is indicated through the lighting means at which intermediate point the measured intermediate voltage value exceeds a predefined value.

6. Method according to one or more of the preceding claims, **characterised in that** the measured chassis voltage value and its application time and/or the measured intermediate voltage value and its application time is/are compared with the values of at least one predefined voltage/time curve accessible to the microprocessor which has a decreasing characteristic from high voltage values at shorter application times to low voltage values at longer application times and an alarm signal is generated if the measured voltage values are greater than the corresponding values on at least one of the predefined voltage / time curves.

7. Method according to claim 6, **characterised in that** if the voltage/time curve is exceeded at an intermediate point or chassis measuring point the intermediate point or chassis measuring point in question is stored and indicated.

8. Method according to one or more of the preceding claims, **characterised in that** by means of a voltage divider the difference between the chassis potential and reference potential and/or the difference between the intermediate potential and reference potential is / are supplied as analogue values to the analogue input of the microprocessor.

9. Method according to one or more of the preceding claims, **characterised in that** a voltage is supplied in series or simultaneously at each intermediate point and the respective difference between the chassis potential and reference potential and the difference between the intermediate potential of the intermediate point at which the voltage is supplied and the reference potential is measured.

10. Method according to one or more of the preceding claims, **characterised in that** if the voltage of the overhead line fluctuates with the load the voltage between the chassis and/or an intermediate point and a load-independent virtual potential is measured, whereby the voltage between the two poles of the overhead line is continuously measured and this is used to compensate the fluctuation.

11. Method according to claim 1 or one or more of the claims 3 to 10, **characterised in that** the reference potential is equal to the virtual potential.

12. Method according to one or more of the preceding claims, **characterised in that** for testing purposes a voltage is supplied one after another or simultaneously at all intermediate points and in each case the difference between the chassis potential and reference potential is measured.

13. Method according to one or more of the preceding claims, **characterised in that** for testing purposes a voltage is supplied one after another or simultaneously at all intermediate points and in each case the difference between the respective intermediate potential and reference potential is measured.

14. Method according to one or more of the preceding claims, **characterised in that** for testing purposes a voltage is supplied to the chassis and the difference between the chassis potential and reference potential is measured.

15. Method according to claim 5, **characterised in that** by activating a reset switch all light emitting diodes assigned to the intermediate points are extinguished.

16. Device for detecting and monitoring over-voltages on a trolley bus,
• wherein the trolley bus is connected to an earthed overhead line network,
• wherein the trolley bus comprises between the chassis (C) and overhead line (0) an at least two-stage isolation system with at least one intermediate isolation level,
• wherein the device comprises a chassis voltage measuring device which is arranged between the chassis (C) and the earthed pole of the overhead line (0) and which measures the difference between the chassis potential and a reference potential,
**characterised in that**
• the intermediate isolation level comprises at least one intermediate point,
• an intermediate voltage measuring device is arranged between each intermediate point and the earthed pole of the overhead line (0), which voltage measuring device measures the difference between the intermediate potential and reference potential,
• and the intermediate voltage measuring device and / or the chassis measuring device comprises a microprocessor (M).

17. Device according to claim 16, **characterised in that** the chassis voltage measuring device and / or the intermediate voltage measuring device comprises a voltage divider (STC, ST1 to ST12).

18. Device according to claim 16 or 17, **characterised in that** it comprises an energy supply unit (EV) decoupled from the overhead line (0) which supplies the microprocessor (M) with energy.

## Revendications

1. Procédé pour la détection et la surveillance de tronçons d'isolement et de tensions de contact dans le trolleybus,
• le trolleybus pouvant être raccordé à un réseau de caténaire relié à la terre,
• le trolleybus comprenant entre le châssis (C) et le caténaire (0) un système d'isolation au moins à deux niveaux avec au moins un niveau intermédiaire d'isolation,
• la différence entre le potentiel de châssis et un potentiel de référence étant mesurée au moyen d'un dispositif de mesure de tension de châssis,
• cette valeur de tension de châssis mesurée étant comparée avec une valeur prédéterminée,
• et un signal d'alarme étant généré lorsque la valeur de tension de châssis dépasse une valeur prédéterminée,
**caractérisé**
• **en ce que** la différence entre le potentiel intermédiaire et le potentiel de référence est mesurée au moyen d'un dispositif de mesure de tension intermédiaire en au moins un point intermédiaire du plan intermédiaire d'isolation,
• **en ce que** le dispositif de mesure de tension intermédiaire et/ou le dispositif de mesure de tension de châssis comprend un microprocesseur (M),
• **en ce que** cette valeur de tension intermédiaire est comparée par le microprocesseur (M) avec une valeur prédéterminée,
• et **en ce qu'**un signal d'alarme est généré par le microprocesseur (M) lorsque la valeur de tension intermédiaire dépasse une valeur prédéterminée.

2. Procédé selon la revendication 1, **caractérisé en ce que** le potentiel de référence est identique au potentiel de la terre.

3. Procédé selon la revendication 1 ou 2, **caractérisé en ce que**, lorsque la valeur de tension de châssis mesurée et/ou la valeur de tension intermédiaire mesurée dépasse une valeur prédéterminée, cette valeur de tension de châssis et/ou valeur de tension intermédiaire est mémorisée.

4. Procédé selon l'une quelconque ou plusieurs des revendications précédentes, **caractérisé en ce qu'**un moyen d'éclairage, en particulier une diode électroluminescente, indique à quel moment la valeur de tension de châssis mesurée dépasse une valeur prédéterminée.

5. Procédé selon l'une quelconque ou plusieurs des revendications précédentes, **caractérisé en ce que** le plan intermédiaire d'isolation présente au moins deux points intermédiaires, **en ce qu'**un moyen d'éclairage, en particulier une diode électroluminescente, est attribué à chaque point intermédiaire et **en ce qu'**on indique par les moyens d'éclairage en quel point intermédiaire la valeur de tension intermédiaire mesurée dépasse une valeur prédéterminée.

6. Procédé selon l'une quelconque ou plusieurs des revendications précédentes, **caractérisé en ce que** la valeur de tension de châssis mesurée et son temps d'application et/ou la valeur de tension intermédiaire mesurée et son temps d'application est comparée avec les valeurs d'au moins une courbe caractéristique tension/temps prédéterminée et accessible au microprocesseur, qui présente une caractéristique qui diminue depuis des valeurs de tension élevées avec des temps d'application assez courts vers des valeurs de tension faibles avec des temps d'application assez longs et **en ce qu'**un signal d'alarme est généré lorsque les valeurs de tension mesurées sont supérieures aux valeurs correspondantes sur au moins l'une des courbes caractéristiques tension/temps prédéterminées.

7. Procédé selon la revendication 6, **caractérisé en ce que**, en cas de dépassement de la courbe caractéristique tension/temps en un point intermédiaire ou en un point de mesure de châssis, le point intermédiaire ou le point de mesure de châssis concerné est mémorisé et affiché.

8. Procédé selon l'une quelconque ou plusieurs des revendications précédentes, **caractérisé en ce que**, par un diviseur de tension, la différence entre le potentiel de châssis et le potentiel de référence et/ou la différence entre le potentiel intermédiaire et le potentiel de référence est fournie sous forme de valeurs analogiques à l'entrée analogique du microprocesseur.

9. Procédé selon l'une quelconque ou plusieurs des revendications précédentes, **caractérisé en ce qu'**une tension est appliquée de façon successive ou simultanée sur chaque point intermédiaire et **en ce qu'**à chaque fois la différence entre le potentiel de châssis et le potentiel de référence ainsi que la différence entre le potentiel intermédiaire du point intermédiaire où s'applique la tension et le potentiel de référence est mesurée.

10. Procédé selon l'une quelconque ou plusieurs des revendications précédentes, **caractérisé en ce que**, lorsque la tension de la caténaire varie avec la charge, la tension entre le châssis et/ou le point intermédiaire et un potentiel virtuel indépendant de la charge est mesurée, la tension entre les deux pôles de la caténaire étant mesurée de façon continue, et ceci étant utilisé pour la compensation de la fluctuation.

11. Procédé selon la revendication 1 ou l'une ou plusieurs des revendications 3 à 10, **caractérisé en ce que** le potentiel de référence est identique au potentiel virtuel.

12. Procédé selon l'une quelconque ou plusieurs des revendications précédentes, **caractérisé en ce qu'**une tension est appliquée sur tous les points intermédiaires de façon successive ou simultanée à des fins d'essai et **en ce qu'**à chaque fois la différence entre le potentiel de châssis et le potentiel de référence est mesurée.

13. Procédé selon l'une quelconque ou plusieurs des revendications précédentes, **caractérisé en ce qu'**une tension est appliquée sur tous les points intermédiaires de façon successive ou simultanée à des fins d'essai et **en ce qu'**à chaque fois la différence entre le potentiel intermédiaire respectif et le potentiel de référence est mesurée.

14. Procédé selon l'une quelconque ou plusieurs des revendications précédentes, **caractérisé en ce qu'**une tension est appliquée sur le châssis à des fins d'essai et **en ce que** la différence entre le potentiel de châssis et le potentiel de référence est mesurée.

15. Procédé selon la revendication 5, **caractérisé en ce que** toutes les diodes électroluminescentes attribuées aux points intermédiaires s'éteignent par l'actionnement d'un interrupteur de réinitialisation.

16. Dispositif pour la détection et la surveillance de surtensions sur un trolleybus,
• le trolleybus étant raccordé à un réseau de caténaire relié à la terre,
• le trolleybus présentant entre le châssis (C) et une caténaire (0) un système d'isolation au moins à deux niveaux comprenant au moins un niveau intermédiaire d'isolation,
• l'appareil comprenant un dispositif de mesure de tension de châssis, qui est branché entre le châssis (C) et le pôle relié à la terre de la caténaire (0) et qui mesure la différence entre le potentiel de châssis et le potentiel de référence,
**caractérisé**
• **en ce que** le plan intermédiaire d'isolation présente au moins un point intermédiaire,
• **en ce qu'**un dispositif de mesure de tension intermédiaire, qui mesure la différence entre le potentiel intermédiaire et le potentiel de référence, est branché entre chaque point intermédiaire et le pôle relié à la terre de la caténaire (0),
• et **en ce que** le dispositif de mesure de tension intermédiaire et/ou le dispositif de mesure de tension de châssis comprend un microprocesseur (M).

17. Dispositif selon la revendication 16, **caractérisé en ce que** le dispositif de mesure de tension de châssis et/ou le dispositif de mesure de tension intermédiaire comprend un diviseur de tension (STC, ST1 à ST12).

18. Dispositif selon la revendication 16 ou 17, **caractérisé en ce qu'**il présente une unité d'alimentation en énergie (EV), dissociée de la caténaire (0), qui alimente le microprocesseur (M) en énergie.
